# EUROPEAN PATENT APPLICATION

(11) **EP 0 793 346 A1**
(43) Date of publication of application: **03.09.1997**
(21) Application number: 97300273.6
(22) Date of filing: 17.01.1997
(51) Int. Cl.: H03K 19/003, H03K 19/017

(54) **Reduced switching current buffer amplifier**

(30) Priority: 28.02.1996 US 608344
(71) Applicant: Hewlett-Packard Company, Palo Alto, California 94304 (US)
(72) Inventor: Watson, Jeffrey John, Philomath, OR 97370 (US)
(74) Representative: Colgan, Stephen James

(57) **Abstract**

Buffer amplifiers are arranged in a branching tree-like structure to distribute a clock signal to many loads in an integrated circuit. In order to reduce switching current and EMI, the buffer amplifiers which are the last buffer amplifiers in the branching structure are comprised of a series coupled first inverting amplifier (301, 305) and a second inverting amplifier (303, 307). These inverting amplifiers are coupled to an input port and an output port of the buffer amplifiers. A non-inverting amplifier (309, 311) of the buffer amplifiers is parallel coupled with the series coupled inverting amplifiers between the input port and the output port.

## Description

### BACKGROUND OF THE INVENTION

The present invention generally relates to an electronic buffer amplifier circuit and more particularly relates to a buffer amplifier circuit having reduced switching current demands such that electromagnetic interference is reduced.

One common application for electronic amplifiers is that of providing power amplification for driving a plurality of loads. When a large number of loads are to be driven, a number of buffer amplifiers are coupled together in a tree-like structure in which the output of one buffer amplifier is split into several paths, each of which is coupled to another buffer amplifier. The output of these other buffer amplifiers is split into several paths and so forth until the last buffer amplifiers in the tree-structure are coupled to the final loads. This tree-like structure is particularly beneficial for certain types of integrated circuits which require a synchronizing signal to coordinate the processes of the integrated circuit. The clock synchronizing signal must be coupled to many subcircuits within the structure of the integrated circuit and this is typically accomplished with a tree-structure of many clock buffer amplifiers.

A clock signal is usually a repetitive or cyclic- signal which is rapidly switched from a low voltage potential to a relatively high voltage potential at a known frequency such that the integrated circuit is synchronized to the clock signal. Rapid switching from one voltage level to another voltage level is well known to generate electromagnetic interference (EMI), which causes undesirable effects not only in the integrated circuit which utilizes the switching buffer amplifiers but also in the larger electronic device which employs the integrated circuit and other devices wholly unrelated to the electronic device. A significant amount of effort and expense is incurred in compensating the device for EMI and shielding the device from radiating EMI to other devices, once the EMI has been created.

It is desirable to suppress the generation of EMI at its source rather than attempting to combat it after it has been generated. To this end, others have devised circuits which reduce EMI generation in switching amplifiers. See, for example, U.S. Patent Application No. 08/412,421, "Predriver Circuit For High Current Loads" filed on behalf of Rajan Walia et al. on March 29, 1995, and assigned to the assignee of the present invention. It is recognized that the amount of EMI generated is related to the slope of the electric current waveform of the current drawn by the switching buffer amplifier. That is, the differential of the switching electric current with time is related to the amount of EMI generated. The waveforms of the figs seem to indicate it is the rate of change of the slope. Controlling the switching current thus offers a possible reduction in EMI generation. However, in some applications, constraints are placed on the type of output signal which is acceptable to the remainder of the circuit and on the geometry or area which can be allocated to the buffer amplifier. Thus, previous solutions do not provide an acceptable answer to the EMI problem.

### SUMMARY OF THE INVENTION

Reduced switching current is realized in a buffer amplifier by series coupling a first inverting amplifier of a first amplifying section to a second inverting amplifier of the first amplifying section. The first amplifying section is coupled to an input port and an output port of the buffer amplifier. A second amplifying section consisting of a non-inverting amplifier is parallel coupled with the first amplifying section between the input port and the output port.

### BRIEF DESCRIPTION OF THE DRAWINGS

FIG. 1 is a schematic diagram of a tree structure of buffer amplifiers which may employ the present invention.

FIG. 2 is a schematic diagram of a conventional semiconductor buffer amplifier which may be employed in the structure of FIG. 1.

FIG. 3 is a schematic diagram of a buffer amplifier which employs the present invention and may be employed in the structure of FIG. 1.

FIGs. 4A, 4B, 4C, and 4D are related current or voltage versus time waveforms indicating the performance of the present invention.

### DETAILED DESCRIPTION OF A PREFERRED EMBODIMENT

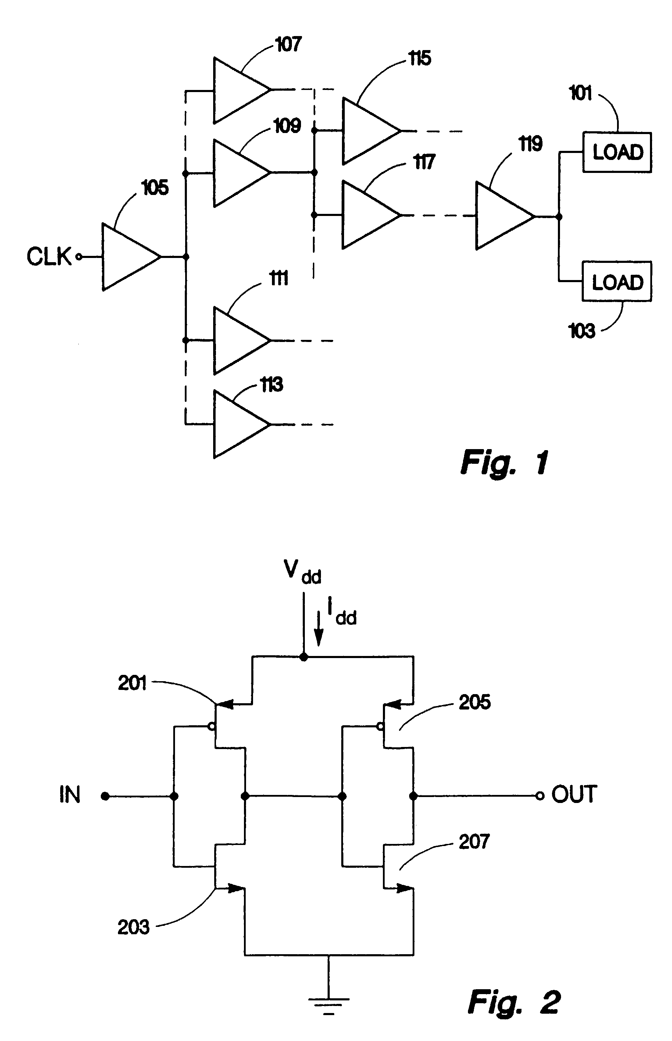

Many integrated circuits must have its operation synchronized for proper operation. A preferred embodiment for the present invention is employed in an integrated circuit known as a standard cell digital ASIC (application specific integrated circuit) . This type of integrated circuit usually requires that a synchronizing clock signal be distributed to thousands of flip-flop circuits on the integrated circuit. In order to reasonably distribute the clock signal within the time delay and skew (the difference in delay between the fastest branch of the tree and the slowest branch) constraints of the integrated circuit, hundreds of clock buffers are arranged in a branching tree-like structure such as that indicated in FIG. 1. A clock signal is input to the clock buffer amplifiers for distribution to the flip-flops or, as indicated in FIG. 1, the loads (shown as load 101 and load 103). Since a single large buffer amplifier presents intractable problems such as excess power consumption, skew, and large area, a smaller input buffer amplifier 105 is coupled to a plurality of second line buffer amplifiers 107, 109, 111, and 113. Each of these second line amplifiers are coupled to a plurality of third line buffer amplifiers, such as buffer amplifiers 115 and 117, which are coupled to second line buffer amplifier 109. This branching continues until the clock drive requirements of all the loads including load 101 and 103 are satisfied. Typically, the last buffer amplifier in the branching chain, such as buffer amplifier 119, is coupled to 5 to 10 loads (or flip-flop cells). Since there are hundreds of such buffer amplifiers distributed throughout the area of the integrated circuit, EMI generated by the switching transients of each buffer amplifier is magnified by the fact that there are so many amplifiers in the integrated circuit. The ASIC device which employs the present invention is ideally suited for a computer peripheral device such as a printer. Since it is possible that many computer peripheral devices will be co-located, the likelihood of interference between the peripheral devices and of interference by the peripheral devices to other EMI sensitive apparatii such as radios and televisions is great. To reduce the EMI, additional filtering and selective layout within each device is accomplished and substantial metal shields are placed in some of the devices to suppress radiation of EMI beyond the device.

Of course, it is desirable to suppress generation of significant EMI at its source, if such suppression is possible. A conventional buffer amplifier which can be employed in the clock buffer string is shown in FIG. 2. Such a buffer amplifier has two inverting amplifiers (N-channel field effect transistor 201 and P-channel field effect transistor 203 arranged as a standard CMOS inverter series connected with N-channel field effect transistor 205 arranged as a standard CMOS inverter with P-channel field effect transistor 207). An input clock signal is applied to the first inverting amplifier 201, 203; the inverted output is applied to the second inverting amplifier 205, 207, which is coupled to an output to provide a non-inverted output clock signal having a two-gate-delay delay. This conventional buffer amplifier has steep rise and fall times associated with its transition from the high state to the low state of the clock signal. Such steep rise and fall times are associated with large di/dt currents and consequently significant EMI generation.

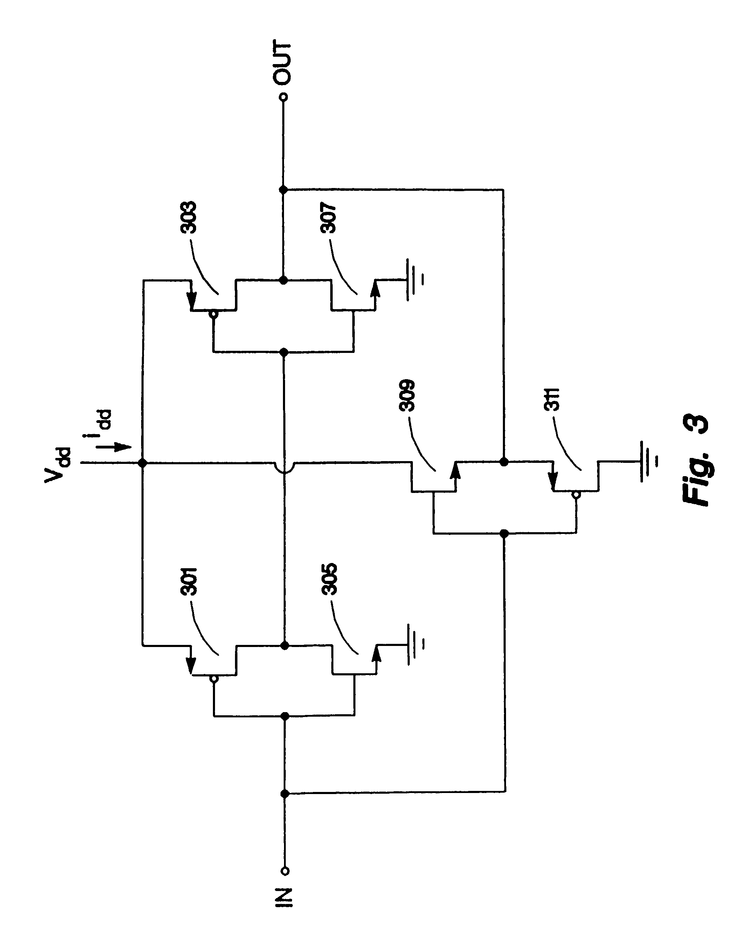

A buffer amplifier circuit having reduced di/dt currents (current spikes) is shown in FIG. 3. This buffer amplifier employs two amplifying sections coupled in parallel between the input and the output ports. The first amplifying section uses two inverting amplifiers coupled in series to produce a non-inverted output signal having a two gate delay from the input signal. The second amplifying section uses a non-inverting amplifier with a single gate delay to produce a non-inverting output at the output port. In the preferred embodiment each of the two inverting amplifiers of the first amplifying section uses an N-channel field effect transistor 301, 303, coupled at the drain to the power supply V_{dd}. A P-channel field effect transistor 305, 307, has its drain coupled to the power supply common, in this case circuit ground. The input clock signal is applied to the gates of both transistors 301 and 305 of the first inverting amplifier and the output is taken from the connection between the drain of field effect transistor 305 and the drain of field effect transistor 301. This output is coupled, then, to the gates of the field effect transistor 303 and field effect transistor 307 of the second inverting amplifier such that the output is a non-inverted clock signal with two gate delays. The input signal is also connected to the second amplifying section of the buffer amplifier, which in the preferred embodiment is two field effect transistors 309 and 311, connected such that the drain of the N-channel field effect transistor 309 is coupled to V_{dd} and the drain of P-channel field effect transistor 311 is coupled to power supply common. The gates of both field effect transistors 309 and 311 are coupled to the input clock signal and the output signal is taken from the connection of the source of field effect transistor 311 and the source of field effect transistor 309. This output signal is connected to the output port of the buffer amplifier and provides a non-inverted output signal with one gate delay.

When the field effect transistors of the reduced switching current buffer amplifier are realized in 0.6 micron CMOS technology, the following device areas are used.

**TABLE 1**

| FET | device width | device length | area |
|---|---|---|---|
| 301 | 4µ | 0.6µ | 2.4µ² |
| 305 | 2µ | 0.6µ | 1.2µ² |
| 303 | 10µ | 0.6µ | 6.0µ² |
| 307 | 5µ | 0.6µ | 3.0µ² |
| 309 | 20µ | 0.6µ | 12.0µ² |
| 311 | 40µ | 0.6µ | 24.0µ² |

The total active area for the reduced switching current buffer amplifier circuit is therefore 48.6µ². This area can be compared to an equivalent total active area of the previous buffer amplifier of FIG. 2 of 50.7µ².

**TABLE 2**

| FET | device width | device length | area |
|---|---|---|---|
| 201 | 16.3µ | 0.6µ | 9.8µ² |
| 203 | 8.2µ | 0.6µ | 4.9µ² |
| 205 | 40.8µ | 0.6µ | 24.5µ² |
| 207 | 19.2µ | 0.6µ | 11.5µ² |

Thus even though there is an additional amplifier in the low switching current buffer amplifier, comparisons of the overall active area demonstrate that the total active areas remain approximately the same. The non-inverting amplifier of the low switching current buffer amplifier is approximately the same size as the second inverting amplifier of the amplifier of FIG. 2 but the two inverting amplifiers of the low switching current buffer amplifier are, together, somewhat smaller than the first inverting amplifier of the buffer amplifier of FIG. 2. This is a result of the fact that the two inverting amplifiers of the low switching current buffer amplifier do not switch a substantial amount of current and do not need any exceptional switching speed. The non-inverting amplifier of the low current switching buffer amplifier, however, must have the higher current switching capability with a high switching speed.

The single non-inverting amplifier of the low switching current buffer amplifier is not sufficient, alone, to drive the output signal to V_{dd} when turned on or to zero potential when turned off. This non-inverting amplifier provides an output voltage in the on condition of one threshold voltage (approximately 0.85V) above 0 volts (ground). The parallel two inverting gates drives the output to V_{dd} when on and to 0V when off. The rail-to-rail voltage swing from V_{dd} to 0V provides increased noise margin and reduced static power consumption.

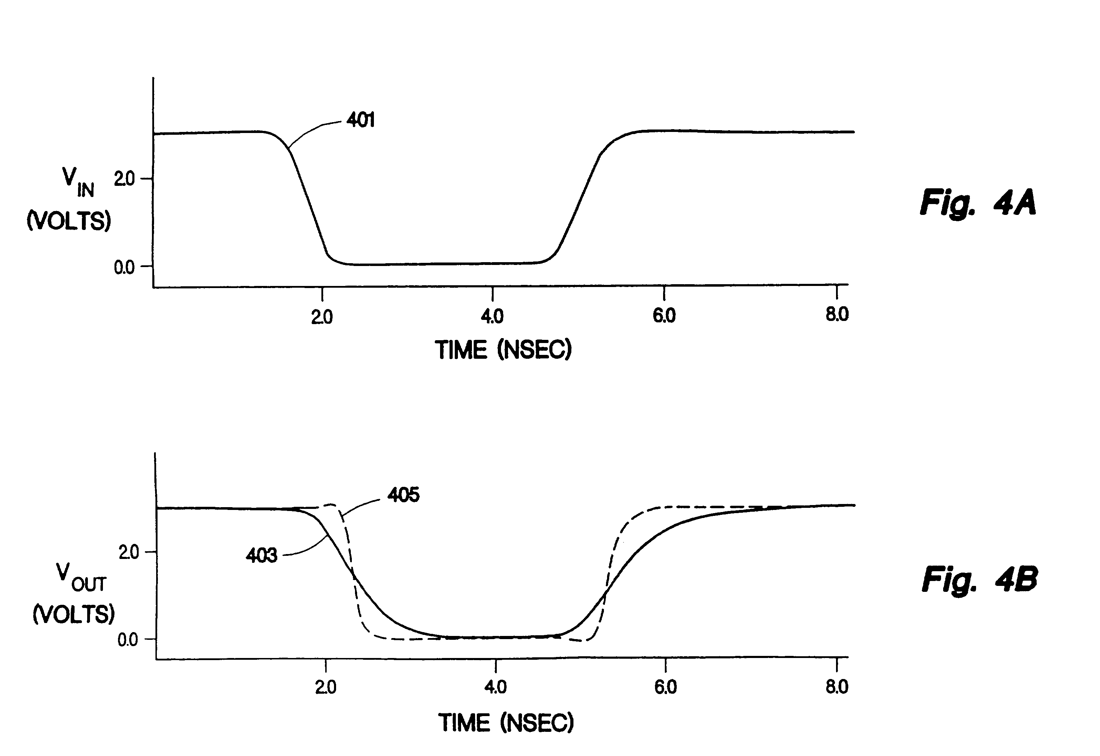

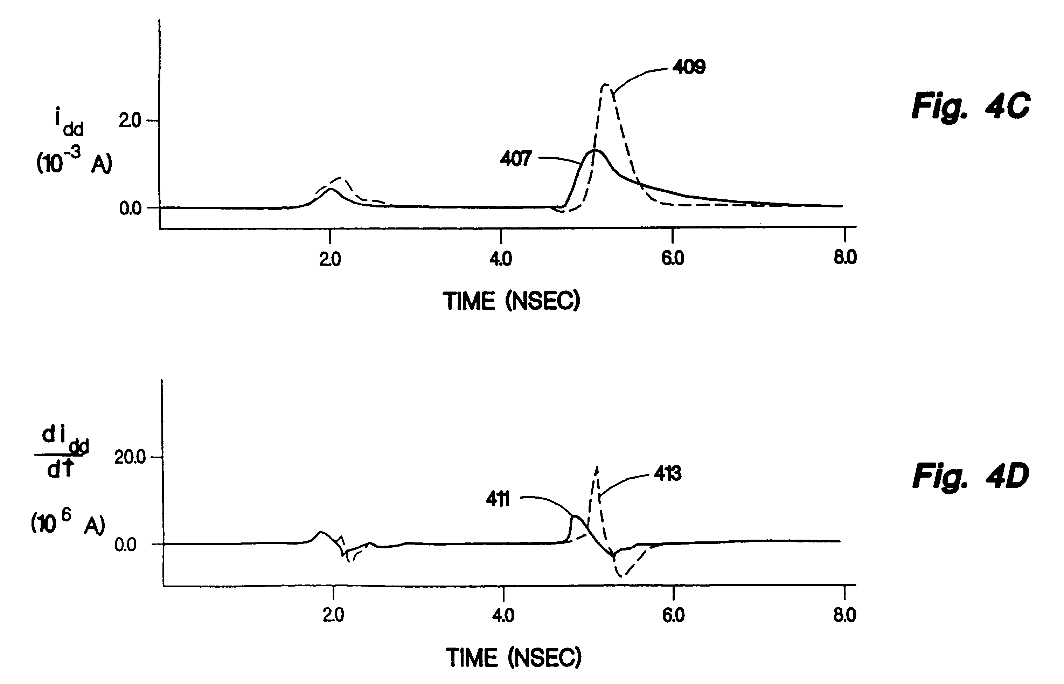

Referring now to FIGs. 4A, 4B, 4C, and 4D, the improvement in switching current performance can be apprehended for the buffer amplifier circuit of the present invention. In FIG. 4A, a input signal Vᵢₙ is represented by curve 401. The output voltage signal Vₒᵤₜ is shown in FIG. 4B. The output waveform of the low switching current buffer amplifier is shown in curve 403 and, for comparison, the voltage output curve is shown in broken line 405 for the buffer circuit of FIG. 2. It should be noted that the switching time (defined as one half the resting output voltage or 1.5 volts) is approximately the same for both curve 403 and curve 405. The output voltage of curve 403 commences its switching earlier than curve 405 as a result of the fact that only one gate delay is present in the non-inverting amplifier of the low current switching buffer amplifier. Later in the switching cycle of curve 403 the effect of the series connected inverted amplifiers takes effect and drives curve 403 to 0 volts. Likewise, curve 403 begins switching earlier than curve 405 and reaches fully to the 3.0 volts V_{dd} after the two gate delay output signal from the two inverting amplifiers takes effect. Switching current i_{dd} is shown in FIG. 4C. The reduced switching current buffer amplifier current is shown in curve 407 and the switching current i_{dd} of the buffer amplifier of FIG. 2 is shown in broken line curve 409. Of particular interest is the slope of the two i_{dd} curves which is shown in FIG. 4D. The di_{dd}/dt of the reduced current buffer amplifier is shown in curve 411 and the di_{dd}/dt of the buffer amplifier of FIG. 2 is shown in broken line 413. The differential current with time of the reduced switching current buffer amplifier is between 1/3 and 1/4 as great as that of the buffer amplifier of FIG. 2. This reduced current slope results in a substantially reduced EMI at the EMI generating source.

Not only does the reduced switching current buffer amplifier provide a reduced EMI generation but the parallel inverting and non-inverting amplifier circuits enable a substantially lower static current drain to be realized over a single non-inverting buffer amplifier stage. This feature is of particular benefit during device testing. One test which is performed at the integrated circuit level is designated I_{ddq}, or quiescent current drain. I_{ddq} values exceeding 5 microamps to 10 microamps indicates excessive leakage of one of the many thousands of gates found on the integrated circuit. Buffer amplifiers having the ability to be placed at either voltage rail (rather than at a threshold voltage above or below the rail) enable an I_{ddq} measurement to be made.

## Claims

1. A buffer amplifier having reduced switching current, comprising:
a first amplifying section connected to an input port and an output port and having a first inverting amplifier (301, 305) series coupled to a second inverting amplifier (303, 307); and
a second amplifying section consisting of a non-inverting amplifier (309, 311), parallel coupled with said first amplifying section between said input port and said output port.

2. A buffer amplifier in accordance with claim 1 wherein said first inverting amplifier of said first amplifying section further comprises an inverting connection of an N-channel transistor (305) and a P-channel transistor (301), said P-channel transistor source coupled to a positive voltage supply and said N-channel source coupled to a supply common.

3. A buffer amplifier in accordance with claim 2 wherein said second inverting amplifier of said first amplifying section further comprises an inverting connection of an N-channel transistor (307) and a P-channel transistor (303), said P-channel transistor source coupled to said positive voltage supply and said N-channel source coupled to said supply common.

4. A buffer amplifier in accordance with claim 1 wherein said non-inverting amplifier of said second amplifying section further comprises a common gate and common source connection of a P-channel transistor (311) and an N-channel transistor (309), said N-channel transistor drain coupled to a positive voltage supply and said P-channel drain coupled to a supply common.

5. An integrated circuit including buffer amplifiers arranged in a branching structure to distribute a switching signal with reduced switching current to signal loads of the integrated circuit, comprising:
a plurality of buffer amplifiers, at least one of said plurality of buffer amplifiers including:
a first amplifying section connected to an input port and an output port and having a first inverting amplifier (301, 305) series coupled to a second inverting amplifier (303, 307); and
a second amplifying section consisting of a non-inverting amplifier (309, 311), parallel coupled with said first amplifying section between said input port and said output port.

6. An integrated circuit in accordance with claim 5 wherein said at least one buffer amplifier is disposed as the last buffer amplifier in the branching structure, coupled to at least one of the signal loads.

7. A method of reducing switching current in a buffer amplifier comprising the steps of:
connecting a first amplifying section to an input port and to an output port;
series coupling a first inverting amplifier (301, 305) of said first amplifying section to a second inverting amplifier (303, 307) of said first amplifying section; and
parallel coupling a second amplifying section consisting of a non-inverting amplifier (309, 311) with said first amplifying section between said input port and said output port.
